# EUROPÄISCHE PATENTSCHRIFT

(11) **EP 2 596 681 B1**
(45) Veröffentlichungstag und Bekanntmachung des Hinweises auf die Patenterteilung: **30.11.2016**
(21) Anmeldenummer: 11731258.7
(22) Anmeldetag: 24.06.2011
(51) Int. Cl.: H05B 33/14, C09K 11/77

(54) **CARBODIIMID-LEUCHTSTOFFE**
CARBODIIMIDE LUMINESCENT SUBSTANCES
SUBSTANCES LUMINESCENTES DE TYPE CARBODIIMIDE

(30) Priorität: 22.07.2010 DE 102010031914
(43) Veröffentlichungstag der Anmeldung: 29.05.2013
(73) Patentinhaber: Merck Patent GmbH, 64293 Darmstadt (DE)
(72) Erfinder: WINKLER, Holger, 64291 Darmstadt (DE); BENKER, Andreas, 64686 Lautertal (DE); PETRY, Ralf, 64347 Griesheim (DE); VOSGROENE, Tim, 64372 Ober-Ramstadt (DE)
(86) Internationale Anmeldenummer: PCT/EP2011/003130
(87) Internationale Veröffentlichungsnummer: WO 2012/010243

(56) Entgegenhaltungen:
- JOCHEN GLASER ET AL: "Synthesis and Properties of Tetracyanamidosilicates ARE[Si(CN 2 ) 4 ]", INORGANIC CHEMISTRY, Bd. 49, Nr. 6, 15. März 2010 (2010-03-15), Seiten 2954-2959, XP55006467, ISSN: 0020-1669, DOI: 10.1021/ic902498p
- MEYER, H.-JUERGEN: "Solid state metathesis reactions as a conceptual tool in the synthesis of new materials", DALTON TRANSACTIONS, Bd. 39, Nr. 26, 22. Mai 2010 (2010-05-22), Seiten 5973-5982, XP000002658466, DOI: 10.1039/c001031f

## Beschreibung

Die Erfindung betrifft Carbodiimid-Verbindungen, Verfahren zur Herstellung dieser Verbindungen und deren Verwendung als Konversionsleuchtstoffe bzw. in Leuchtmitteln.

LEDs gewinnen zunehmend an Bedeutung - sowohl als Beleuchtungsmittel als auch bei der Verwendung als Hintergrundbeleuchtung in Flüssigkristall-Displays (FK-Displays). Diese neuartigen Lichtquellen weisen gegenüber den herkömmlichen Kaltkathodenfluoreszenzlampen (cold cathode fluorescence lamps - CCFL) mehrere Vorteile auf, wie längere Lebensdauer, potentielle Energieersparnis, Abwesenheit schädlicher Inhaltsstoffe (wie Quecksilber in CCFL).

In den letzten Jahren wurden vermehrt Aufsätze publiziert, die sich mit Leuchtstoffen auf Carbodiimid-Basis befassen. Konkret geht es hier um Verbindungen, die das Carbodiimid-Anion (CN₂)²⁻ als zentrale Baueinheit aufweisen und mit Ce³⁺, Eu³⁺ oder Tb³⁺ dotiert sein können. Beispiele hierfür sind Gd₂(CN₂)₃:Ce³⁺ und Gd₂(CN₂)₃:Tb³⁺ (J. Glaser et al., Inorg. Chem. 2008, 47, 10455-10460 sowie Y₂O₂(CN₂):Eu³⁺ (J. Sindlinger et al., Z. Anorg. Allg. Chem. 2007, 633, 1686-1690).

Der Nachteil der genannten Leuchtstoffe besteht jedoch darin, dass sie sich nicht bei der Emissionswellenlänge der blauen LED (i.e. 440-460 nm) anregen lassen, weshalb sie nicht als Leuchtstoffe für Weißlicht-LEDs in Frage kommen.

Des Weiteren sind sogenannte Silicocarbodiimide bekannt (J. Glaser und H.-J. Meyer, Angew. Chem. 2008, 120, 7658-7661), wobei diese bisher nur undotiert vorliegen und damit als Leuchtstoffe nicht in Frage kommen.

Überraschenderweise wurde nun gefunden, dass mit Eu-dotierte Orthosilikat-strukturanaloge Verbindungen effiziente Leuchtstoffe darstellen, welche im blauen und UV Bereich des sichtbaren Spektrums zu grün bis roter Fluoreszenz angeregt werden können.

Eine erste Ausführungsform der vorliegenden Erfindung ist daher eine Verbindung der Formel I,

EA_{2-y}Si(CN₂)₄₋ₓOₓ:Eu_{y} (I)

wobei
EA steht für ein oder mehrere Elemente ausgewählt aus Mg, Ca, Sr, Ba oder Zn und
x steht für einen Wert aus dem Bereich von 0 bis 3,9 und
y steht für einen Wert aus dem Bereich von 0,01 bis 0,4.

Im Gegensatz zu den Orthosilikat-Leuchtstoffen weisen diese als Erdalkalisilicocarbodiimid zu bezeichnenden Verbindungen keine Instabilität gegen Feuchtigkeit auf. Zusätzlich zeigen die erfindungsgemäßen Leuchtstoffe eine Rotverschiebung der Emissionswellenlänge im Vergleich zu den Orthosilikaten, was durch die etwas höhere Kovalenz der Carbodiimidgruppe im Vergleich zum Sauerstoff begründet ist.

Vorzugsweise steht x für einen Wert aus dem Bereich 0 bis 3,0, und insbesondere bevorzugt aus dem Bereich 0 bis 2,5.

Vorzugsweise steht y für einen Wert aus dem Bereich 0,02 bis 0,35, und insbesondere bevorzugt aus dem Bereich 0,04 bis 0,30.

In einer weiteren Ausführungsform können die Verbindungen gemäß Formel I zusätzlich Alkalimetalle wie Na, K oder Li enthalten.

Erfindungsgemäße Leuchtstoffe in geringen Mengen eingesetzt ergeben bereits gute LED-Qualitäten. Die LED-Qualität wird dabei über übliche Parameter, wie beispielsweise den Color Rendering Index oder den Farbpunkt in CIE x und CIE y Koordinaten beschrieben.

Der Color Rendering Index oder CRI ist eine dem Fachmann geläufige, einheitslose lichttechnische Größe, welche die Farbwiedergabetreue einer künstlichen Lichtquelle mit derjenigen des Sonnenlichtes bzw. und Filamentlichtquellen vergleicht (die beiden letztgenannten besitzen einen CRI von 100).

CIE x und CIE y stehen für die Koordinaten im dem dem Fachmann geläufigen CIE Normfarbdiagramm (hier Normalbeobachter 1931), mit denen die Farbe einer Lichtquelle beschrieben wird.
Alle oben aufgeführten Größen werden nach dem Fachmann geläufigen Methoden aus Emissionsspektren der Lichtquelle berechnet.

Im Kontext dieser Anmeldung wird als grüne Emission oder grünes Licht solches Licht bezeichnet, dessen Intensitätsmaximum zwischen 508 und 550 nm Wellenlänge liegt, entsprechend wird als gelb solches Licht bezeichnet, dessen Maximum zwischen 551 und 585 nm Wellenlänge liegt und als rotes Licht, dessen Maximum zwischen 610 und 670 nm Wellenlänge liegt.

Ein weiterer Erfindungsgegenstand ist ein Verfahren zur Herstellung einer Verbindung der Formel I.
Hierzu werden in einem Schritt a) mindestens 3 Edukte ausgewählt aus Calcium-, Strontium-, Barium-, Magnesium-, Zink-, Silicium- und/oder Europium-haltigen Materialien gemischt und das Gemisch im Schritt b) gegebenenfalls noch mit einem anorganischen oder organischen Stoff versetzt und dann in einem Schritt c) thermisch nachbehandelt, vorzugsweise unter reduktiven Bedingungen.

Bei der oben genannten thermischen Behandlung ist es bevorzugt, wenn diese zumindest teilweise unter reduzierenden Bedingungen durchgeführt wird. Im Schritt b) erfolgt die Umsetzung üblicherweise bei einer Temperatur oberhalb 800 C, vorzugsweise bei einer Temperatur oberhalb 1000°C und insbesondere bevorzugt im Bereich von 1100°C - 1300°C. Die reduktiven Bedingungen werden dabei z.B. mit Kohlenmonoxid, Formiergas oder Wasserstoff oder zumindest Vakuum oder Sauerstoffmangel-Atmosphäre eingestellt, bevorzugt im Stickstoffstrom, vorzugsweise im N₂/H₂ -Strom und insbesondere bevorzugt im N₂/H₂-Strom (95 - 80 : 5 - 20) eingestellt.

Als anorganischen oder organischen Stoff (im Schritt b) wird ein Stoff aus der Gruppe der Ammoniumhalogenide, vorzugsweise Ammoniumchlorid oder Erdalkalifluoride wie Calcium-, Strontium- oder Bariumfluorid oder Flussmittel wie Borate, Borsäure oder Alkoholate, Oxalate und/oder Kieselsäureester wie Tetraethylorthosilikat (TEOS) eingesetzt.

In einer weiteren Ausführungsform kann der Leuchtstoff zusätzlich mindestens einen weiteren der folgenden Leuchtstoffmaterialien enthalten: Oxide, Molybdate, Wolframate, Vanadate, Granate, Silicate, Aluminate, Nitride und Oxinitride jeweils einzeln oder Gemischen derselben mit einem oder mehreren Aktivatorionen wie Ce, Eu, Mn, Cr und/oder Bi. Dies ist besonders dann von Vorteil, wenn bestimmte Farbräume eingestellt werden sollen.

Das Absorptions- und Emissionsspektrum, das thermische Löschverhalten und die Abklingzeit τ_{1/e} von lumineszierenden Materialien gemäß der Formel I hängen stark von der exakten Zusammensetzung der bivalenten Kationen ab. Ausschlaggebend für die oben genannten spektroskopischen Eigenschaften ist die Kristallfeldaufspaltung des 5d-Bands des Eu²⁺ sowie der kovalente Charakter der Eu-O bzw. der Eu-N-C- Bindungen.

Die Partikelgröße der erfindungsgemäßen Leuchtstoffe beträgt üblicherweise zwischen 50 nm und 30 µm, vorzugsweise zwischen 1 µm und 20 µm.

In einer weiteren bevorzugten Ausführungsform besitzen die Leuchtstoffe in Partikelform eine geschlossene Oberflächenbeschichtung, die aus SiO₂, TiO₂, Al₂O₃, ZnO, ZrO₂ und/oder Y₂O₃ oder Mischoxide daraus besteht. Diese Oberflächenbeschichtung hat den Vorteil, dass durch eine geeignete Abstufung der Brechungsindices der Beschichtungsmaterialien eine Anpassung des Brechungsindex mit der Umgebung erzielt werden kann. In diesem Fall wird die Streuung des Lichtes an der Oberfläche des Leuchtstoffes verringert und ein größerer Anteil des Lichtes kann in den Leuchtstoff eindringen und dort absorbiert und konvertiert werden. Außerdem ermöglicht es die Brechungsindex-angepasste Oberflächebeschichtung, dass mehr Licht aus dem Leuchtstoff ausgekoppelt wird, weil die interne Totalreflexion verringert wird.

Zudem ist eine geschlossene Schicht dann vorteilhaft, wenn der Leuchtstoff verkapselt werden muss. Dies kann erforderlich sein, um einer Empfindlichkeit des Leuchtstoffes oder Teilen davon gegen diffundierendes Wasser oder andere Materialien in der unmittelbaren Umgebung zu entgegnen. Ein weiterer Grund für die Verkapselung mit einer geschlossenen Hülle ist eine thermische Entkoppelung des eigentlichen Leuchtstoffes von der Wärme, die im Chip entsteht. Diese Wärme führt zu einer Verringerung der Fluoreszenzlichtausbeute des Leuchtstoffes und kann auch die Farbe des Fluoreszenzlichts beeinflussen. Schließlich ist es möglich durch eine solche Beschichtung die Effizienz des Leuchtstoffes zu erhöhen, indem im Leuchtstoff entstehende Gitterschwingungen in ihrer Ausbreitung an die Umgebung gehindert werden.

Außerdem bevorzugt ist es, wenn die Leuchtstoffe eine poröse Oberflächenbeschichtung besitzen, die aus SiO₂, TiO₂, Al₂O₃, ZnO, ZrO₂ und/oder Y₂O₃ oder Mischoxide daraus oder aus der Leuchtstoffzusammensetzung besteht. Diese porösen Beschichtungen bieten die Möglichkeit, den Brechungsindex einer Einfachschicht weiter zu reduzieren. Die Herstellung solcher poröser Beschichtungen kann nach drei herkömmlichen Methoden geschehen, wie sie in WO 03/027015 beschrieben werden:
das Ätzen von Glas (z.B. Natron-Kalk-Gläser (siehe US 4019884)), das Aufbringen einer porösen Schicht und die Kombination aus poröser Schicht und einem Ätzvorgang. In einer weiteren bevorzugten Ausführungsform besitzen die Leuchtstoffpartikel eine Oberfläche, die funktionelle Gruppen trägt, welche eine chemische Anbindung an die Umgebung, vorzugsweise bestehend aus Epoxy- oder Silikonharz ermöglicht. Diese funktionellen Gruppen können z.B. über Oxogruppen angebundene Ester oder andere Derivate sein, die mit Bestandteilen der Bindemittel auf Basis von Epoxiden und / oder Silikonen Verknüpfungen eingehen können. Solche Oberflächen haben den Vorteil, dass eine homogene Einmischung der Leuchtstoffe in das Bindemittel ermöglicht wird. Des Weiteren können dadurch die rheologischen Eigenschaften des Systems Leuchtstoff / Bindemittel und auch die Topfzeiten in einem gewissen Masse eingestellt werden. Damit wird die Verarbeitung der Gemische vereinfacht.

Da die auf dem LED Chip aufgebrachte erfindungsgemäße Leuchtstoffschicht vorzugsweise aus einem Gemisch von Silikon und homogenen Leuchtstoffpartikeln besteht, welches im Volumenguss aufgebracht wird, und das Silikon eine Oberflächenspannung aufweist, ist diese Leuchtstoffschicht auf mikroskopischer Ebene nicht einheitlich bzw. ist die Dicke der Schicht nicht durchweg konstant. Dies ist in der Regel auch der Fall wenn der Leuchtstoff nicht nach dem Volumengussverfahren, sondern im sogenannten Chip-Level-Konversionsverfahren, bei dem eine hochkonzentrierte, dünne Leuchtstoffschicht mit Hilfe von elektrostatischen Methoden direkt auf die Oberfläche des Chips appliziert wird, aufgebracht wird.

Mit Hilfe des o.g. Verfahrens können beliebige äußere Formen der Leuchtstoffpartikel hergestellt werden, wie sphärische Partikel, Plättchen und strukturierte Materialien und Keramiken.

Die Herstellung von plättchenförmigen Leuchtstoffen als weitere bevorzugte Ausführungsform geschieht nach herkömmlichen Verfahren aus den entsprechenden Metall- und/oder Seltenerd-Salzen. Das Herstellverfahren ist in EP 763573 und DE 102006054331 ausführlich beschrieben.

Diese plättchenförmigen Leuchtstoffe können hergestellt werden, indem ein natürlicher oder synthetisch hergestellter hoch stabiler Träger bzw. ein Substrat aus beispielsweise Glimmer-, SiO₂-, Al₂O₃-, ZrO₂, Glas- oder TiO₂-Plättchen, welches ein sehr großes Aspektverhältnis aufweist, eine atomar glatte Oberfläche und eine einstellbare Dicke besitzt, durch Fällungsreaktion in wässriger Dispersion oder Suspension mit einer Leuchtstoffschicht beschichtet werden kann. Neben Glimmer, ZrO₂, SiO₂, Al₂O₃, Glas oder TiO₂ oder Gemischen derselben können die Plättchen auch aus dem Leuchtstoffmaterial selbst bestehen, oder aus einem Material aufgebaut sein. Falls das Plättchen selbst lediglich als Träger für die Leuchtstoffbeschichtung dient, muss diese aus einem Material bestehen, welches transparent für die Primärstrahlung der LED ist, oder die Primärstrahlung absorbiert und diese Energie auf die Leuchtstoffschicht überträgt. Die plättchenförmigen Leuchtstoffe werden in einem Harz (z.B. Silikon- oder Epoxidharz), dispergiert und diese Dispersion wird auf dem LED Chip aufgebracht.

Die plättchenförmigen Leuchtstoffe können in Dicken von 50 nm bis zu etwa 20 µm, vorzugsweise zwischen 150 nm und 5 µm, grosstechnisch hergestellt werden. Der Durchmesser beträgt dabei von 50 nm bis 20 µm. Er besitzt in der Regel ein Aspektverhältnis (Verhältnis des Durchmessers zur Teilchendicke) von 1: 1 bis 400 : 1, und insbesondere 3 : 1 bis 100 : 1. Die Plättchenausdehnung (Länge x Breite) ist von der Anordnung abhängig. Plättchen eignen sich auch als Streuzentren innerhalb der Konversionsschicht, insbesondere dann, wenn sie besonders kleine Abmessungen aufweisen.

Die dem LED Chip zugewandte Oberfläche des erfindungsgemäßen plättchenförmigen Leuchtstoffes kann mit einer Beschichtung versehen werden, welche entspiegelnd in Bezug auf die von dem LED Chip emittierte Primärstrahlung wirkt. Dies führt zu einer Verringerung der Rückstreuung der Primärstrahlung, wodurch diese besser in den erfindungsgemäßen Leuchtstoffkörper eingekoppelt werden kann.

Hierfür eignen sich beispielsweise brechzahlangepasste Beschichtungen, die eine folgende Dicke d aufweisen müssen: d = [Wellenlänge der Primärstrahlung des LED Chips /(4* Brechzahl der Leuchtstoffkeramik)], s. beispielsweise Gerthsen, Physik, Springer Verlag, 18. Auflage, 1995. Diese Beschichtung kann auch aus photonischen Kristallen bestehen. Wobei hierunter auch eine Strukturierung der Oberfläche des plättchenförmigen Leuchtstoffes fällt, um bestimmte Funktionalitäten zu erreichen.

Die Herstellung der erfindungsgemäßen Leuchtstoffe in Form von keramischen Körpern erfolgt analog nach dem in der DE 102006037730 (Merck) beschriebenen Verfahren.

Dabei wird der Leuchtstoff durch Mischen der entsprechenden Edukte und Dotierstoffe nasschemisch hergestellt, anschließend isostatisch verpresst und in Form eines homogenen dünnen und nicht porösen Plättchens direkt auf die Oberfläche des Chips aufgebracht. Somit findet keine ortsabhängige Variation der Anregung und Emission des Leuchtstoffes statt, wodurch die damit ausgerüstete LED einen homogenen und farbkonstanten Lichtkegel emittiert und über eine hohe Lichtleistung verfügt. Die keramischen Leuchtstoffkörper können z.B. als Plättchen in Dicken von einigen 100 nm bis zu etwa 500 µm großtechnisch hergestellt werden. Die Plättchenausdehnung (Länge x Breite) ist von der Anordnung abhängig. Bei direkter Aufbringung auf den Chip ist die Größe des Plättchens gemäß der Chipausdehnung (von ca. 100 µm * 100 µm bis zu mehreren mm²) mit einem gewissen Übermaß von ca. 10% - zu 30% der Chipoberfläche bei geeigneter Chipanordnung (z.B. Flip-Chip-Anordnung) oder entsprechend zu wählen. Wird das Leuchtstoffplättchen über einer fertigen LED angebracht, so ist der austretende Lichtkegel vollständig vom Plättchen zu erfassen.

Die Seitenflächen des keramischen Leuchtstoffkörpers können mit einem Leicht- oder Edelmetall, vorzugsweise Aluminium oder Silber verspiegelt werden. Die Verspiegelung bewirkt, dass kein Licht lateral aus dem Leuchtstoffkörper austritt. Lateral austretendes Licht kann den aus der LED auszukoppelnden Lichtstrom verringern. Die Verspiegelung des keramischen Leuchtstoffkörpers erfolgt in einem Prozessschritt nach der isostatischen Verpressung zu Stangen oder Plättchen, wobei vor der Verspiegelung eventuell ein Schneiden der Stangen oder Plättchen in die erforderliche Größe erfolgen kann. Die Seitenflächen werden hierzu z.B. mit einer Lösung aus Silbernitrat und Glucose benetzt und anschließend bei erhöhter Temperatur einer Ammoniak-Atmosphäre ausgesetzt. Hierbei bildet sich z.B. ein silberner Belag auf den Seitenflächen aus.
Alternativ bieten sich auch stromlose Metallisierungsverfahren an, siehe beispielsweise Hollemann-Wiberg, Lehrbuch der Anorganischen Chemie, Walter de Gruyter Verlag oder Ullmanns Enzyklopädie der chemischen Technologie.
Der keramische Leuchtstoffkörper kann, falls erforderlich, mit einer Wasserglaslösung auf dem Untergrund eines LED Chip fixiert werden.

In einer weiteren Ausführungsform besitzt der keramische Leuchtstoffkörper auf der, einem LED Chip entgegengesetzten Seite eine strukturierte (z.B. pyramidale) Oberfläche. Somit kann möglichst viel Licht aus dem Leuchtstoffkörper ausgekoppelt werden. Die strukturierte Oberfläche auf dem Leuchtstoffkörper wird dadurch hergestellt, in dem beim isostatischen Verpressen das Presswerkzeug eine strukturierte Pressplatte aufweist und dadurch eine Struktur in die Oberfläche prägt. Strukturierte Oberflächen sind dann gewünscht, wenn möglichst dünne Leuchtstoffkörper bzw. Plättchen hergestellt werden sollen. Die Pressbedingungen sind dem Fachmann bekannt (siehe J. Kriegsmann, Technische keramische Werkstoffe, Kap. 4, Deutscher Wirtschaftsdienst, 1998). Wichtig ist, dass als Presstemperaturen 2/3 bis zu 5/6 der Schmelztemperatur des zu verpressenden Stoffes verwendet werden.

Die Anregbarkeit der erfindungsgemäßen Leuchtstoffe erstrecken sich zudem über einen weiten Bereich, der von etwa 410 nm bis 530 nm, bevorzugt 430 nm bis zu etwa 500 nm reicht. Damit sind diese Leuchtstoffe nicht nur zur Anregung durch UV oder blau emittierende Lichtquellen wie LEDs oder konventionelle Entladungslampen (z.B. auf Hg-Basis) geeignet, sondern auch für Lichtquellen wie solche, welche die blaue In³⁺ -Linie bei 451 nm ausnutzen.

Ein weiterer Gegenstand der vorliegenden Erfindung ist eine Lichtquelle, dadurch gekennzeichnet, dass diese einen Halbleiter und mindestens einen Leuchtstoff nach Formel I enthält. Vorzugsweise ist diese Beleuchtungseinheit weiß emittierend oder emittiert Licht mit einem bestimmten Farbpunkt (Color-on-demand-Prinzip).

Unter dem color-on-demand Konzept versteht man die Realisierung von Licht eines bestimmten Farbpunktes mit einer pcLED (= phosphor converted LED) unter Einsatz eines oder mehrer Leuchtstoffe. Dieses Konzept wird z.B. verwendet, um bestimmte Corporate Designs, z.B. für beleuchtete Firmenlogos, Marken etc. zu erzeugen.

In einer bevorzugten Ausführungsform der erfindungsgemäßen Lichtquelle handelt es sich bei dem Halbleiter um ein lumineszentes IndiumAluminiumGalliumNitrid, insbesondere der Formel
InᵢGaⱼAlₖN, wobei 0 ≤ i, 0 ≤ j, 0 ≤ k, und i+j+k=1 ist.

In einer weiteren bevorzugten Ausführungsform der erfindungsgemäßen Lichtquelle handelt es sich bei der Lichtquelle um eine lumineszente auf ZnO, TCO (Transparent conducting oxide), ZnSe oder SiC basierende Anordnung oder auch um eine auf einer organischen lichtemittierenden Schicht basierende Anordnung (OLED).

In einer weiteren bevorzugten Ausführungsform der erfindungsgemäßen Lichtquelle handelt es sich bei der Lichtquelle um eine Quelle, die Elektrolumineszenz und/oder Photolumineszenz zeigt. Weiterhin kann es sich bei der Lichtquelle auch um eine Plasma- oder Entladungsquelle handeln.

Dem Fachmann sind mögliche Formen von derartigen Lichtquellen bekannt. Es kann sich hierbei um lichtemittierende LED-Chips unterschiedlichen Aufbaus handeln.

Die erfindungsgemäßen Leuchtstoffe können entweder in einem Harz dispergiert (z.B. Epoxy- oder Siliconharz), oder bei geeigneten Größenverhältnissen direkt auf der Lichtquelle angeordnet werden oder aber von dieser, je nach Anwendung, entfernt angeordnet sein (letztere Anordnung schließt auch die "Remote phosphor Technologie" mit ein). Die Vorteile der "Remote phosphor Technologie" sind dem Fachmann bekannt und z.B. der folgenden Publikation zu entnehmen: Japanese Journ. of Appl. Phys. Vol. 44, No. 21 (2005). L649-L651.

Weitere Erfindungsgegenstände sind eine Beleuchtungseinheit, insbesondere zur Hintergrundbeleuchtung von Anzeigevorrichtungen, die dadurch gekennzeichnet ist, dass sie mindestens eine oben beschriebene Lichtquelle enthält und entsprechende Anzeigevorrichtungen, insbesondere Flüssigkristallanzeigevorrichtung (LC Display), mit einer Hintergrundbeleuchtung, die dadurch gekennzeichnet sind, dass sie mindestens eine solche Beleuchtungseinheit enthalten.

Weiterhin bevorzugt ist eine Beleuchtungseinheit, insbesondere zur Allgemeinbeleuchtung, die dadurch gekennzeichnet ist, dass sie einen CRI > 60, vorzugsweise > 70, noch bevorzugter >80 aufweist. Ein CRI >80 ist in einer LED allerdings nur realisierbar, wenn man mindestens zwei erfindungsgemäße Carbodiimid-Leuchtstoffe z.B. aus den Beispielen 1, 2 und/oder 3 miteinander kombiniert.

In einer weiteren Ausführungsform ist es bevorzugt, wenn die optische Ankopplung der Beleuchtungseinheit zwischen dem Leuchtstoff und dem Halbleiter durch eine lichtleitende Anordnung realisiert wird.
Dadurch ist es möglich, dass an einem zentralen Ort der Halbleiter installiert wird und dieser mittels lichtleitender Vorrichtungen, wie beispielsweise lichtleitenden Fasern, an den Leuchtstoff optisch angekoppelt ist. Auf diese Weise lassen sich den Beleuchtungswünschen angepasste Leuchten lediglich bestehend aus einem oder unterschiedlichen Leuchtstoffen, die zu einem Leuchtschirm angeordnet sein können, und einem Lichtleiter, der an den Halbleiter angekoppelt ist, realisieren. Auf diese Weise ist es möglich, eine starke Lichtquelle an einen für die elektrische Installation günstigen Ort zu platzieren und ohne weitere elektrische Verkabelung, sondern nur durch Verlegen von Lichtleitern an beliebigen Orten Leuchten aus Leuchtstoffen, welche an die Lichtleiter gekoppelt sind, zu installieren.

Ein weiterer Gegenstand der vorliegenden Erfindung ist die Verwendung der erfindungsgemäßen Leuchtstoffe zur teilweisen oder vollständigen Konversion der blauen oder im nahen UV-liegenden Emission einer Lumineszenzdiode.

Weiterhin bevorzugt ist die Verwendung der erfindungsgemäßen Leuchtstoffe zur Konversion der blauen oder im nahen UV-liegenden Emission in sichtbare weiße Strahlung. Weiterhin ist die Verwendung der erfindungsgemäßen Leuchtstoffe zur Konversion der Primärstrahlung in einen bestimmten Farbpunkt nach dem "Color on demand- Konzept" bevorzugt.

Ein weiterer Gegenstand der vorliegenden Erfindung ist die Verwendung der erfindungsgemäßen Leuchtstoffe in Elektrolumineszenz-Materialien, wie beispielsweise Elektrolumineszenz-Folien (auch Leuchtfolien oder Lichtfolien genannt), in denen beispielsweise Zinksulfid oder Zinksulfid dotiert mit Mn²⁺, Cu⁺, oder Ag⁺ als Emitter eingesetzt wird, die im gelbgrünen Bereich emittieren. Die Anwendungsbereiche der Elektrolumineszenz-Folie sind z.B. Werbung, Displayhintergrundbeleuchtung in Flüssigkristallbildschirmen (LC-Displays) und Dünnschichttransistor-Displays (TFT-Displays), selbstleuchtende KFZ-Kennzeichenschilder, Bodengrafik (in Verbindung mit einem tritt- und rutschfesten Laminat), in Anzeigen- und/oder Bedienelementen beispielsweise in Automobilen, Zügen, Schiffen und Flugzeugen oder auch Haushalts-, Garten-, Mess- oder Sport- und Freizeitgeräten.

Die folgenden Beispiele sollen die vorliegende Erfindung verdeutlichen. Sie sind jedoch keinesfalls als limitierend zu betrachten. Alle Verbindungen oder Komponenten, die in den Zubereitungen verwendet werden können, sind entweder bekannt und käuflich erhältlich oder können nach bekannten Methoden synthetisiert werden. Die in den Beispielen angegebenen Temperaturen gelten immer in °C. Es versteht sich weiterhin von selbst, dass sich sowohl in der Beschreibung als auch in den Beispielen die zugegebenen Mengen der Komponenten in den Zusammensetzungen immer zu insgesamt 100% addieren. Gegebene Prozentangaben sind immer im gegebenen Zusammenhang zu sehen. Sie beziehen sich üblicherweise aber immer auf die Masse der angegebenen Teil- oder Gesamtmenge.

Auch ohne weitere Ausführungen wird davon ausgegangen, dass ein Fachmann die obige Beschreibung in weitestem Umfang nutzen kann. Die bevorzugten Ausführungsformen sind deswegen lediglich als beschreibende, keinesfalls als in irgendeiner Weise limitierende Offenbarung aufzufassen. Die folgenden Beispiele sollen die vorliegende Erfindung verdeutlichen. Sie sind jedoch keinesfalls als limitierend zu betrachten. Alle Verbindungen oder Komponenten, die in den Zubereitungen verwendet werden können, sind entweder bekannt und käuflich erhältlich oder können nach bekannten Methoden synthetisiert werden.

### Beispiel 1: Herstellung eines grün emittierenden Leuchtstoffes Ba_{1,74}Sr_{0,18}Si(CN₂)_{1,92}O_{2,08}:Eu_{0,08}²⁺

6,16 g Ba(CN₂), 0,46 g Sr(CN₂), 1,2 g SiO₂ und 0,28 g Eu₂O₃ werden mit 0,8 g NH₄Cl versetzt und in einem Mörser gründlich vermischt. Das entstandene Gemisch wird in einen Ofen überführt und dort 6 Stunden bei 1200 °C unter einer Stickstoff-Wasserstoffatmosphäre (90:10) kalziniert. Nach Abkühlung wird der entstandene Leuchtstoff in einer Mörsermühle zerkleinert und über ein 20µ-Sieb klassiert.
Ermittelter Farbwert nach CIE: x = 0,294; y= 0,631

### Beispiel 2: Herstellung eines gelb emittierenden Leuchtstoffes Ba_{0,85}Sr_{1,05} Si(CN₂)_{1,9}O_{2,1}:Eu_{0,1}²⁺

3,0 g Ba(CN₂), 2,68 g Sr(CN₂), 1,2 g SiO₂ und 0,35 g Eu₂O₃ werden mit 0,75 g NH₄Cl versetzt und in einem Mörser gründlich vermischt. Das entstandene Gemisch wird in einen Ofen überführt und dort 6 Stunden bei 1200 °C unter einer Stickstoff-Wasserstoffatmosphäre (90:10) kalziniert. Nach Abkühlung wird der entstandene Leuchtstoff in einer Mörsermühle zerkleinert und über ein 20µ-Sieb klassiert.
Ermittelter Farbwert nach CIE: x = 0,499; y= 0,537

### Beispiel 3: Herstellung eines rot emittierenden Leuchtstoffes Sr_{1,0}Ca_{0,8} Si(CN₂)_{1,8}O_{2,2}:Eu_{0,2}²⁺

2,54 g Sr(CN₂), 1,28 g Ca(CN₂) 1,2 g SiO₂ und 0,70 g Eu₂O₃ werden mit 0,6 g NH₄Cl versetzt und in einem Mörser gründlich vermischt. Das entstandene Gemisch wird in einen Ofen überführt und dort 6 Stunden bei 1200 °C unter einer Stickstoff-Wasserstoffatmosphäre (90:10) kalziniert. Nach Abkühlung wird der entstandene Leuchtstoff in einer Mörsermühle zerkleinert und über ein 20µ-Sieb klassiert.
Ermittelter Farbwert nach CIE: x = 0,621; y= 0,378

### Beispiel 4: Herstellung einer Leuchtdiode

Der Leuchtstoff aus Beispiel 1 wird in einem Taumelmischer mit einem 2-Komponenten Silikon (OE 6550 der Fa. Dow Corning) gemischt, so dass gleiche Mengen des Leuchtstoffs in den beiden Komponenten des Silikons dispergiert sind; die Gesamtkonzentration des Leuchtstoffs im Silikon beträgt 8 Gew.-%.

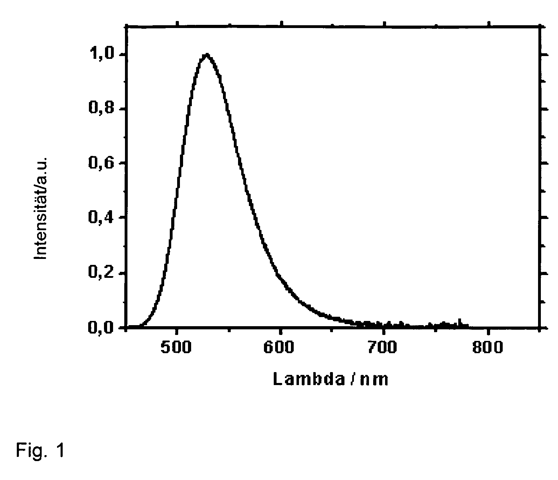

5 ml jeder der beiden Leuchtstoff enthaltenden Silikon Komponenten werden homogen miteinander gemischt und in einen Dispenser überführt. Mit Hilfe des Dispensers werden leere LED packages von der Fa. OSA optoelectronics, Berlin, welche einen 100 µm² großen GaN Chip enthalten, befüllt. Danach werden die LEDs in eine Wärmekammer gestellt, um über 1 h bei 150°C das Silikon zu verfestigen.
Das Emissionsspektrum der LED nach Beispiel 1 ist in Figur 1 angegeben.

CIE x und CIE y stehen für die Koordinaten im dem dem Fachmann geläufigen CIE Normfarbdiagramm (hier Normalbeobachter 1931), mit denen die Farbe einer Lichtquelle beschrieben wird.
Alle oben aufgeführten Größen werden nach dem Fachmann geläufigen Methoden aus Emissionsspektren der Lichtquelle berechnet.

"CRI" steht für den sog. "Color Rendering Index", dies ist eine dem Fachmann geläufige, einheitslose lichttechnische Größe, welche die Farbwiedergabetreue einer künstlichen Lichtquelle mit derjenigen des Sonnenlichtes bzw. und Filamentlichtquellen vergleicht (die beiden letztgenannten besitzen einen CRI von 100).

### Beschreibung der Figuren

**Fig. 1****:** Das Emissionsspektrum des Leuchtstoffs aus Beispiel 1 (Peak bei 530 nm). (Die Emissionsmessung wurde an einer optisch unendlich dicken Schicht des Leuchtstoffes bei einer Anregung von 450 nm mit einem Edinburgh Instruments Spektrometer OC290 bei Raumtemperatur durchgeführt.)

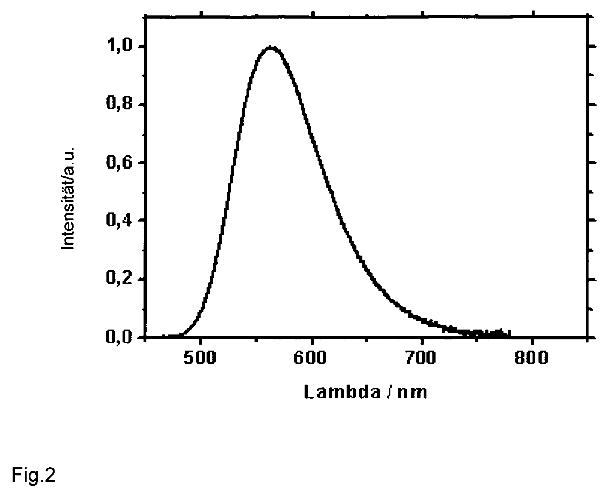

**Fig. 2****:** Das Emissionsspektrum des Leuchtstoffs aus Beispiel 2 (Peak bei 560 nm). (Die Emissionsmessung wurde an einer optisch unendlich dicken Schicht des Leuchtstoffes bei einer Anregung von 450 nm mit einem Edinburgh Instruments Spektrometer OC290 bei Raumtemperatur durchgeführt.)

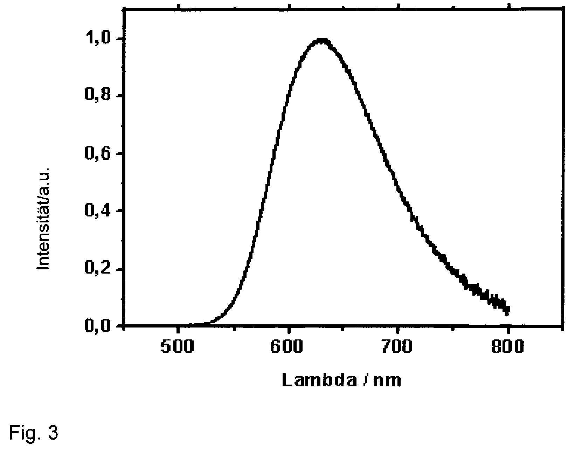

**Fig. 3****:** Das Emissionsspektrum des Leuchtstoffs aus Beispiel 3 (Peak bei 630 nm). (Die Emissionsmessung wurde an einer optisch unendlich dicken Schicht des Leuchtstoffes bei einer Anregung von 450 nm mit einem Edinburgh Instruments Spektrometer OC290 bei Raumtemperatur durchgeführt.)

## Patentansprüche

1. Verbindung der Formel I
EA_{2-y}Si(CN₂)₄₋ₓOₓ:Eu_{y} (I)
wobei
EA steht für ein oder mehrere Elemente ausgewählt aus Mg, Ca, Sr, Ba oder Zn und
x steht für einen Wert aus dem Bereich von 0 bis 3,9 und
y steht für einen Wert aus dem Bereich von 0,01 bis 0,4.

2. Verbindung nach Anspruch 1, **dadurch gekennzeichnet, dass** x steht für einen Wert aus dem Bereich von 0 bis 3,0, vorzugsweise aus dem Bereich von 0 bis 2,5.

3. Verbindung nach Anspruch 1 oder 2, **dadurch gekennzeichnet, dass** y steht für einen Wert aus dem Bereich von 0,02 bis 0,35, vorzugsweise aus dem Bereich von 0,04 bis 0,30.

4. Verfahren zur Herstellung einer Verbindung gemäß einem oder mehreren der Ansprüche 1 bis 3 umfassend folgende Verfahrensschritte:
a) Mischen von mindestens 3 Edukten ausgewählt aus Calcium-, Strontium-, Barium-, Magnesium-, Zink-, Silicium- und/oder Europium-haltigen Materialien,
b) gegebenenfalls Zugabe mindestens eines weiteren anorganischen oder organischen Stoffes,
c) thermische Nachbehandlung der Verbindung

5. Verfahren nach Anspruch 4, **dadurch gekennzeichnet, dass** die anorganischen oder organischen Stoffe (Verfahrenschritt b) ausgewählt werden aus der Gruppe der Ammoniumhalogenide, vorzugsweise Ammoniumchlorid, Erdalkalifluoride wie Calcium-, Strontium- oder Bariumfluorid, Borate, Borsäure, Carbonate wie Ammoniumhydrogencarbonat, Alkoholate, Oxalate und/oder Kieselsäureester wie Tetraethylorthosilikat (TEOS).

6. Lichtquelle, **dadurch gekennzeichnet, dass** diese mindestens einen Halbleiter und mindestens einen Leuchtstoff nach Formel I gemäß einem oder mehreren der Ansprüche 1 bis 3 enthält.

7. Lichtquelle nach Anspruch 6, **dadurch gekennzeichnet, dass** es sich bei dem Halbleiter um ein lumineszentes IndiumAluminiumGalliumNitrid, insbesondere der Formel InᵢGaⱼAlₖN, wobei 0 ≤ i, 0 ≤ j, 0 ≤ k, und i+j+k=1 handelt.

8. Beleuchtungseinheit, insbesondere zur Hintergrundbeleuchtung von Anzeigevorrichtungen, **dadurch gekennzeichnet, dass** sie mindestens eine Lichtquelle nach den Ansprüchen 6 oder 7 enthält.

9. Beleuchtungseinheit nach Anspruch 8, **dadurch gekennzeichnet, dass** die optische Ankopplung zwischen dem Leuchtstoff und dem Halbleiter durch eine lichtleitende Anordnung realisiert ist.

10. Anzeigevorrichtung, insbesondere Flüssigkristallanzeigevorrichtung (LC Display), mit einer Hintergrundbeleuchtung, **dadurch gekennzeichnet, dass** sie mindestens eine Beleuchtungseinheit nach Anspruch 8 oder 9 enthält.

11. Verwendung von mindestens einer Verbindung nach einem oder mehreren der Ansprüche 1 bis 3 als Konversionsleuchtstoff zur teilweisen oder vollständigen Konversion der blauen oder im nahen UV-liegenden Emission einer Lumineszenzdiode.

12. Verwendung von mindestens einer Verbindung nach einem oder mehreren der Ansprüche 1 bis 3 als Konversionsleuchtstoff zur Konversion der Primärstrahlung in einen bestimmten Farbpunkt nach dem Color-on-demand-Konzept.

## Claims

1. Compound of the formula I
EA_{2-y}Si(CN₂)₄₋ₓOₓ:Eu_{y} (I)
where
EA stands for one or more elements selected from Mg, Ca, Sr, Ba or Zn and
x stands for a value from the range from 0 to 3.9 and
y stands for a value from the range from 0.01 to 0.4.

2. Compound according to Claim 1, **characterised in that** x stands for a value from the range from 0 to 3.0, preferably from the range from 0 to 2.5.

3. Compound according to Claim 1 or 2, **characterised in that** y stands for a value from the range from 0.02 to 0.35, preferably from the range from 0.04 to 0.30.

4. Process for the preparation of a compound according to one or more of Claims 1 to 3, comprising the following process steps:
a) mixing of at least 3 starting materials selected from calcium-, strontium-, barium-, magnesium-, zinc-, silicon- and/or europium-containing materials,
b) optionally addition of at least one further inorganic or organic substance,
c) thermal aftertreatment of the compound.

5. Process according to Claim 4, **characterised in that** the inorganic or organic substances (process step b) are selected from the group of ammonium halides, preferably ammonium chloride, alkaline-earth metal fluorides, such as calcium fluoride, strontium fluoride or barium fluoride, borates, boric acid, carbonates, such as ammonium hydrogencarbonate, alcoholates, oxalates and/or silicates, such as tetraethyl orthosilicate (TEOS).

6. Light source, **characterised in that** it comprises at least one semiconductor and at least one phosphor of the formula I according to one or more of Claims 1 to 3.

7. Light source according to Claim 6, **characterised in that** the semiconductor is a luminescent indium aluminium gallium nitride, in particular of the formula InᵢGaⱼAlₖN, where 0 ≤ i, 0 ≤ j, 0 ≤ k, and i + j + k = 1.

8. Lighting unit, in particular for the backlighting of display devices, **characterised in that** it comprises at least one light source according to Claim 6 or 7.

9. Lighting unit according to Claim 8, **characterised in that** the optical coupling between the phosphor and the semiconductor is achieved by a light-conducting arrangement.

10. Display device, in particular liquid-crystal display device (LC display), having backlighting, **characterised in that** it comprises at least one lighting unit according to Claim 8 or 9.

11. Use of at least one compound according to one or more of Claims 1 to 3 as conversion phosphor for the partial or complete conversion of the blue or near-UV emission from a luminescent diode.

12. Use of at least one compound according to one or more of Claims 1 to 3 as conversion phosphor for the conversion of the primary radiation into a certain colour point in accordance with the colour-on-demand concept.

## Revendications

1. Composé de la formule I :
EA_{2-y}Si(CN₂)₄₋ₓOₓ:Eu_{y} (I)
dans laquelle :
EA représente un ou plusieurs élément(s) choisi(s) parmi Mg, Ca, Sr, Ba ou
Zn et
x représente une valeur dans la plage de 0 à 3,9 et
y représente une valeur dans la plage de 0,01 à 0,4.

2. Composé selon la revendication 1, **caractérisé en ce que** x représente une valeur dans la plage de 0 à 3,0, de façon préférable dans la plage de 0 à 2,5.

3. Composé selon la revendication 1 ou 2, **caractérisé en ce que** y représente une valeur dans la plage de 0,02 à 0,35, de façon préférable dans la plage de 0,04 à 0,30.

4. Procédé pour la préparation d'un composé selon une ou plusieurs des revendications 1 à 3, comprenant les étapes de procédé qui suivent :
a) mélange d'au moins 3 matériaux de départ choisis parmi des matériaux contenant du calcium, du strontium, du baryum, du magnésium, du zinc, du silicium et/ou de l'europium,
b) en option, ajout d'au moins une autre substance inorganique ou organique,
c) post-traitement thermique du composé.

5. Procédé selon la revendication 4, **caractérisé en ce que** les substances inorganiques ou organiques (étape de procédé b) sont choisies parmi le groupe constitué par les halogénures d'ammonium, de façon préférable le chlorure d'ammonium, les fluorures des métaux des terres alcalines ou alcalinoterreux, tels que le fluorure de calcium, le fluorure de strontium, le fluorure de baryum, les borates, l'acide borique, les carbonates, tels que l'hydro-gènecarbonate d'ammonium, les alcoolates, les oxalates et/ou les silicates, tels que l'orthosilicate de tétraéthyle (TEOS).

6. Source de lumière, **caractérisée en ce qu'**elle comprend au moins un semiconducteur et au moins un phosphore de la formule I selon une ou plusieurs des revendications 1 à 3.

7. Source de lumière selon la revendication 6, **caractérisée en ce que** le semiconducteur est un nitrure d'indium aluminium gallium luminescent, en particulier de la formule InᵢGaⱼAlₖN, dans laquelle 0 ≤ i, 0 ≤ j, 0 ≤ k, et i + j + k = 1.

8. Unité d'éclairage, en particulier pour l'éclairage arrière de dispositifs d'affichage, **caractérisée en ce qu'**elle comprend au moins une source de lumière selon la revendication 6 ou 7.

9. Unité d'éclairage selon la revendication 8, **caractérisée en ce que** le couplage optique entre le phosphore et le semiconducteur est réalisé au moyen d'un agencement de conduction de lumière.

10. Dispositif d'affichage, en particulier dispositif d'affichage à cristaux liquides (affichage LC), comportant un éclairage arrière, **caractérisé en ce qu'**il comprend au moins une unité d'éclairage selon la revendication 8 ou 9.

11. Utilisation d'au moins un composé selon une ou plusieurs des revendications 1 à 3 en tant que phosphore de conversion pour la conversion partielle ou complète d'une émission de bleu ou des UV proches en provenance d'une diode luminescente.

12. Utilisation d'au moins un composé selon une ou plusieurs des revendications 1 à 3 en tant que phosphore de conversion pour la conversion du rayonnement primaire selon un certain point de couleur conformément au concept de couleur à la demande.
